Europäisches Patentamt

European Patent Office

Office européen des brevets

(19)

(11) Numéro de publication: **0 133 394
B1**

(12) **FASCICULE DE BREVET EUROPÉEN**

(45) Date de publication du fascicule du brevet:
14.10.87

(21) Numéro de dépôt: **84401510.7**

(22) Date de dépôt: **18.07.84**

(51) Int. Cl.⁴: **H 01 S 3/13,** H 01 S 3/02,
H 01 S 3/08

(54) **Source lumineuse infrarouge comprenant un laser à semiconducteur associé à des moyens de sélection de mode et d'asservissement en puissance.**

(30) Priorité: **25.07.83 FR 8312249**

(43) Date de publication de la demande:
**20.02.85 Bulletin 85/8**

(45) Mention de la délivrance du brevet:
**14.10.87 Bulletin 87/42**

(84) Etats contractants désignés:
**BE CH DE GB IT LI NL SE**

(56) Documents cité:
**EP-A-0 084 003
EP-A-0 101 374
DE-A-2 931 526
FR-A-2 191 309
US-A-4 297 651**

**ELECTRONICS LETTERS, vol. 18, no. 25, 9 décembre
1982, pages 1092-1094, Hitchin Herts., GB; K.R.
PRESTON: "Simple spectral control technique for
external cavity laser transmitters"**

(73) Titulaire: **Auffret, René, Kernu Louannec, F-22700
Perros Guirec (FR)**
Titulaire: **Le Marer, René, Kerougant Bras, F-22730
Tregastel (FR)**
Titulaire: **Sorel, Yvon, Kernu, Louannec, F-22700
Perros Guirec (FR)**

(72) Inventeur: **Auffret, René, Kernu Louannec, F-22700
Perros Guirec (FR)**
Inventeur: **Le Marer, René, Kerougant Bras, F-22730
Tregastel (FR)**
Inventeur: **Sorel, Yvon, Kernu, Louannec, F-22700
Perros Guirec (FR)**

(74) Mandataire: **Mongrédien, André, c/o BREVATOME
25, rue de Ponthieu, F-75008 Paris (FR)**

EP 0 133 394 B1

## Description

La présente invention a pour objet une source lumineuse infra-rouge comprenant un laser à semiconducteur associé à des moyens de sélection de mode et d'asservissement en puissance selon le préambule de la revendication 1. Une telle source lumineuse est connue de la revue: "Electronics Letters, Vol. 18, No. 25, Dec. 1982, p. 1092-1094. L'invention trouve une application dans la réalisation d'une source à 1,55 µm destinée aux liaisons optiques à grande distance.

Les fibres optiques travaillant à 1,55 µm conçues pour les télécommunications optiques à grande distance présentent une très faible atténuation (0,3 à 0,5 dB/km). Mais leur dispersion en longueur d'onde reste importante (0,15 ps.nm.km). Pour des liaisons à longue distance, 50 km par exemple, il est donc nécessaire d'utiliser des sources lumineuses à spectre très étroit, de l'ordre de quelques dizièmes de nanomètres.

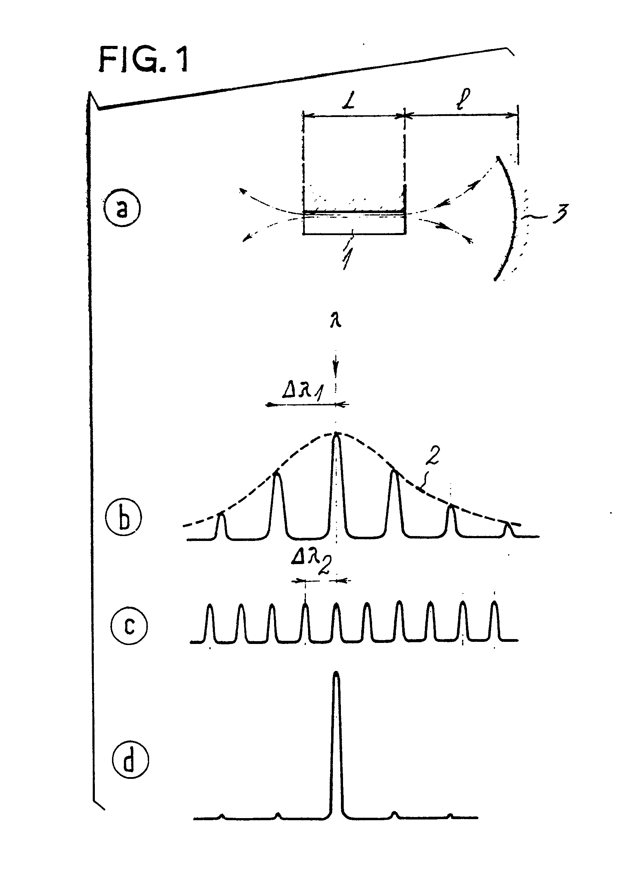

Or, les lasers à semiconducteurs habituels à guidage par le gain ou par l'indice, présentent des largeurs spectrales de quelques nanomètres, largeur qui augmente encore en présence de modulation. Pour réduire cette largeur on utilise une technique de sélection de mode, appelée encore contre-réaction optique, qui permet de rendre la source monofréquence. Le principe de cette contre-réaction optique est illustré sur la figure 1.

Le laser 1 représenté sur la figure 1a est constitué d'un résonateur PEROT-FABRY dont les fréquences de résonance sont séparées de $\Delta\lambda_1$, peu différent de la quantité:

$$\frac{\lambda^2}{2nL}$$

où $\lambda$ est la longueur d'onde de la source,
L la longueur de la cavité PEROT-FABRY,
n l'indice effectif du matériau.

La courbe de gain 2 du milieu amplificateur sélectionne certaines de ces fréquences. Ces fréquences définissent les modes longitudinaux de la cavité (figure 1b). Un laser est monochromatique ou encore monomode longitudinal, lorsqu'un seul de ces modes est présent (généralement le plus énergétique).

L'adjonction d'un miroir externe 3 (figure 1a) à proximité du laser et à une distance 1 de l'ordre de la longueur L de celui-ci, avec une courbure épousant la forme du front d'onde du rayonnement émis par le laser, modifie l'état de résonance de ce dernier. Le résonateur constitué par ce miroir sphérique et le miroir plan le plus éloigné possède une longueur L + 1. Il lui correspond des fréquences de résonance (figure 1c) écartées de $\Delta\lambda_2$ dont la valeur est proche de

$$\frac{\lambda^2}{2(nL+1)}$$

La coïncidence des résonances de la cavité principale de longueur L et de la cavité auxiliaire de longueur L + 1 permet, par ajustement de la position du miroir 3, de sélectionner un des modes de la cavité principale (figure 1d).

Par exemple, pour un laser de 200 µm de longueur, dont l'indice effectif moyen est de 3,5, la séparation entre modes longitudinaux est de 1.6 nm (16 Å) soit un écart de fréquence de 214 GHz.

Il faut observer par ailleurs, en plus de la sélection de mode, produite par l'adjonction du miroir 3 une réduction de la finesse de la raie émise. Celle-ci est proportionnelle au coefficient de qualité de la cavité PEROT-FABRY, lui-même relié au coefficient de réflexion des miroirs et à la longueur de la cavité. Pour des coefficients de réflexion élevés, la largeur des pics de résonance de la cavité a pour expression approchée:

$$\frac{c(1-r)}{2\pi n l}$$

où c est la vitesse de la lumière et r le coefficient de réflexion des miroirs. Pour le laser évoqué plus haut, cette largeur est de l'ordre de 100 GHz.

En augmentant le coefficient de réflexion r par l'adjonction d'un miroir extérieur, on réduit donc cette largeur et cela de façon d'autant plus importante que le chemin optique est plus long. Avec un miroir externe distant de la cavité principale d'une longueur égale à celle du laser et avec un coefficient de réflexion du miroir externe de 80 %, la largeur de raie est sensiblement réduite et tombe à quelques GHz.

Cette technique de sélection de mode, ou de contre-réaction optique, appliquée aux lasers à semiconducteur, est décrite notamment dans l'article de K.R. PRESTON intitulé "Simple spectral control technique for external cavity laser transmitters" publié dans la revue "Electronics Letters" du 9 Décembre 1982, vol. 18, n° 25 ainsi que dans l'article de R. RIES et F. SPORLEDER intitulé "Low frequency instabilities of laser diodes with optical feedback" publié dans les Comptes-Rendus de la Conférence Européenne sur les Communications Optiques (ECOC) qui s'est tenue à Cannes les 21-24 Septembre 1982.

On sait, par ailleurs, que les lasers à semiconducteurs peuvent être asservis en puissance par une contre-réaction en courant. En mesurant la puissance lumineuse émise par le laser on peut former un signal électrique apte à commander le circuit d'alimentation du laser afin que cette puissance reste constante. Une telle technique est décrite par exemple dans le brevet américain 4 293 827 délivré le 6 Octobre 1981 à D.R. SCIFRES et R.D. BURNHAM et intitulé "Hybrid semiconductor Laser-detectors". Dans un tel système un photodétecteur reçoit la lumière émise par la face arrière clivée du résonateur du laser, la face avant laissant passer le faisceau utile. Le photodetecteur alimente un amplificateur, lequel commande une source de courant qui alimente l'élément semiconducteur du laser. Une boucle d'asservissement est ainsi créée.

La présente invention propose de combiner ces deux moyens (sélection optique et asservissement en puissance) dans une disposition qui présente de réels avantages du point de vue de la construction de la source. Il faut en effet garder à l'esprit le fait que, dans le domaine des lasers à semiconducteur destinés aux télécommunications optiques, la stabilité (mécanique, électrique, optique, thermique, etc...) des structures est un élément capital et que cette stabilité est souvent impossible à obtenir si l'on ne prend pas de précautions spéciales. Or l'invention prévoit justement une disposition originale, qui permet, non seulement de combiner la sélection optique et l'asservissement en puissance, mais surtout de conduire à une structure d'une grande robustesse et d'une bonne stabilité.

Cette disposition reprend l'idée d'utiliser un miroir de sélection disposé en regard de la face arrière du laser, et préconise de donner à ce miroir une certaine transmission et de disposer le photorécepteur entrant dans la boucle d'asservissement de puissance, derrière ce miroir, le couplage optique entre le miroir et le photorécepteur peut être assuré par une fibre optique maintenue par un support. Selon l'invention, le miroir auxiliaire sert donc à la fois de sélecteur de mode et de moyen de prélèvement d'une partie de la puissance aux fins d'asservissement.

Par ailleurs, selon une autre caractéristique d'un mode particulier de réalisation de l'invention, le faisceau utile est prélevé par la face avant du laser, à l'aide d'une seconde fibre optique maintenue par un support. Cette double utilisation des deux faisceaux émis par le laser suppose que celui-ci présente des faces dégagées. D'où l'utilisation d'un support particulier en forme de toit. L'ensemble de ces moyens repose sur un socle muni d'un dispositif de régulation de température.

Selon une autre caractéristique d'un mode particulier de réalisation de l'invention, tous les moyens composant la source sont intégrés dans un même boîtier grâce à divers supports moulés en résine. Ces supports sont mis en place, réglés en position, puis immobilisés à l'aide d'une résine identique à celle des supports.

Dans la description qui va suivre, des exemples de réalisation de l'invention sont donnés à titre explicatif et nullement limitatif. Cette description se réfère à des dessins annexés sur lesquels:

- la figure 1, déjà décrite, illustre le principe de la sélection de mode,
- la figure 2 représente, en coupe, un schéma d'une source lumineuse conforme à l'invention,
- la figure 3 représente une embase laser utilisée dans l'invention,
- la figure 4 montre divers éléments de la source,
- la figure 5 illustre la manière de monter ces divers éléments.

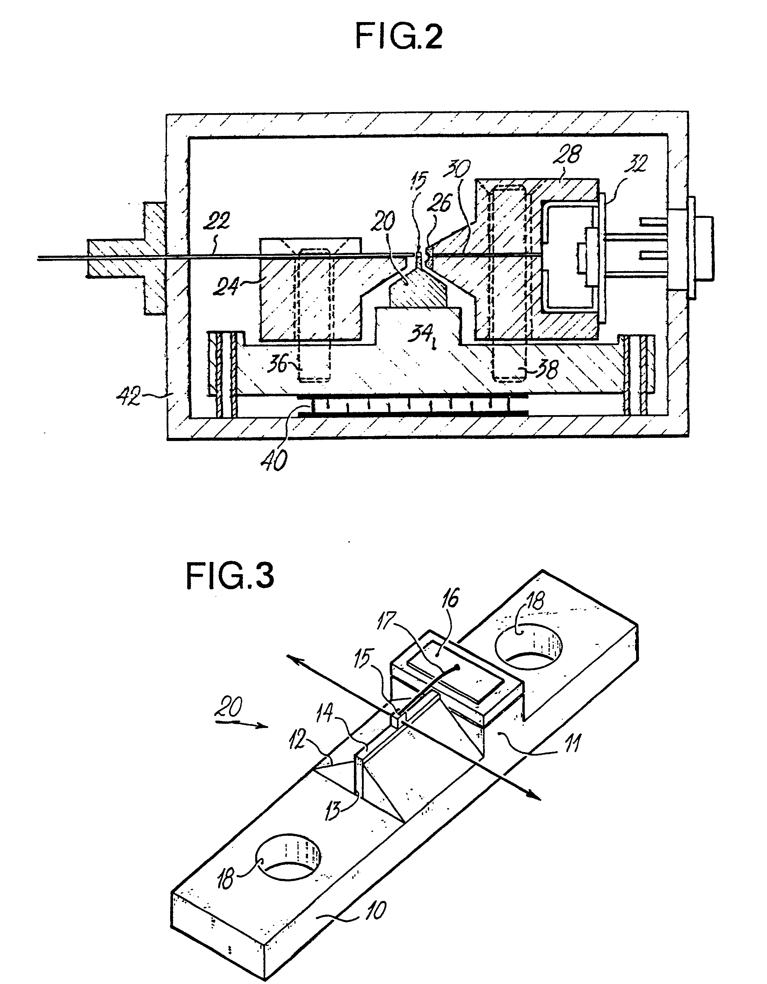

Le dispositif représenté sur la figure 2 comprend une puce laser 15 montée au sommet d'une embase 20 en forme de toit, une fibre optique 22 tenue par un support 24, un miroir sphérique 26 servant de sélecteur de mode, ce miroir étant solidaire d'un support 28, une fibre optique 30 disposée à l'arrière de ce miroir et un photodétecteur 32. L'ensemble repose sur une semelle 34 dans laquelle s'engagent des piges calibrées 36 et 38 servant à maintenir les supports 24 et 28. Sous cette semelle, on trouve un module thermoélectrique 40. L'ensemble est contenu dans un boîtier 42.

Le faisceau délivré par une telle source est guidé par la fibre 22. Le laser possède, de manière classique, deux faces réfléchissantes (faces clivées en général) et émet deux rayonnements transversalement au faîte du toit formé par l'embase.

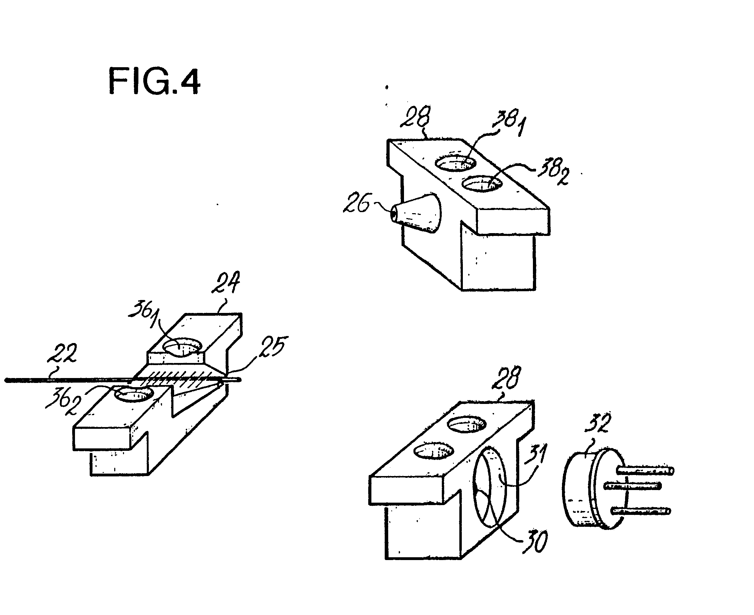

Les figures 3 et 4 montrent plus en détail les divers sous-ensembles de ce dispositif.

L'embase représentée sur la figure 3 comprend un support métallique monobloc 10 présentant une partie prismatique 12 formée par deux plans également inclinés par rapport au plan de symétrie de l'ensemble. Cette partie prismatique est percée d'une fente 13 pratiquée dans le plan de symétrie. Une lamelle métallique 14 est brasée dans la fente. Cette lamelle présente un champ supérieur poli destiné à recevoir la puce laser 15. La longueur de cette puce est égale à l'épaisseur de la lamelle. Le rayonnement laser est donc dirigé transversalement. L'embase comprend encore un socle 11 sur lequel est brasée une plaquette d'interconnexion 16 de forme parallélépipédique. Le support peut comprendre des trous de fixation 18.

On conçoit que la forme prismatique 12 dégage la puce laser et les miroirs sans pour autant nuire au contact thermique qui reste établi sur la totalité de la base de la puce laser.

Une telle embase peut être obtenue de la manière suivante. Le support est obtenu par fraisage et rectification d'un rond ou d'un étiré de cuivre. On obtient le socle 11 et la partie prismatique 12. La fente 13 est obtenue par sciage sur fraiseuse à l'aide d'une fraise-scie de largeur telle qu'on obtienne en une seule passe la largeur souhaitée. Celle-ci est égale à l'épaisseur de la lamelle à monter, augmentée de 30 à 40 μm. Un ébavurage est ensuite effectué, suivi d'un dégraissage aux solvants chlorés ou fluorés dans un bac à ultrasons.

La lamelle est réalisée de préférence en cuivre comme le support. Des bandes de métal sont laminées puis découpées à la longueur correcte à l'aide d'une fraise-scie. Après découpe, les lamelles sont nettoyées à l'aide d'un solvant chloré ou fluoré. Chaque lamelle subit alors une rectification sur trois faces et fait ensuite l'objet d'un polissage sur la face destinée à recevoir la puce laser.

La plaquette d'interconnexion peut être constituée d'un substrat en alumine frittée recouvert d'une couche conductrice servant à l'interconnexion et réalisée par sérigraphie d'une pâte à l'or sans verre. La face inférieure, servant à la fixation sur le socle du support, est recouverte d'une couche obtenue à l'aide d'une pâte argent-palladium.

La lamelle est fixée par brasage tendre dans la fente pratiquée dans le support. L'alliage d'apport est choisi en fonction de sa température de fusion et des caractéristiques de tenue thermique demandée à l'embase. Par exemple, pour une tenue à 160°C, on peut utiliser un alliage étain 62,5 %, plomb 36 %, argent 1,5 % dont la température de fusion est 179°C. Pour une tenue à 200°C, on peut utiliser un alliage étain 95 % antimoine 5 % dont la température de fusion est 240°C.

La figure 4 représente les supports 24 et 28. Le premier comprend une rainure de centrage 25 dans laquelle est posée la fibre 22. Le support est réalisé par moulage à l'aide d'une résine. Il est fixé dans la semelle 34 par des piges calibrées d'ancrage 36, qui empruntent les alésages $36_1$, $36_2$. Ces piges sont préalablement fixées à la semelle 34. La résine utilisée pour constituer le support 24 est employée pour fixer le support sur les piges. Le jeu nécessaire à l'opération est de l'ordre de 1/10e de mm. Le retrait de ces résines étant de 5/1000 c'est donc un déplacement de l'ordre du demi-micron que l'on peut obtenir au cours de la polymérisation, ce qui entraîne des pertes de couplage de 1 à 2 dB.

La même technique est utilisée pour le support de miroir 28. Il est en résine et est fixé sur la semelle 34 à l'aide de piges d'ancrage, empruntant des alésages $38_1$, $38_2$. Ces piges sont, elles aussi, immobilisées par la résine ayant servi à réaliser le support.

Le miroir est par exemple une calotte sphérique de 580 µm de diamètre en résine pure. Son rayon de courbure est le plus proche possible du front d'onde du laser. Le miroir reçoit une couche d'or de 10 nm (100 Å) permettant une réflexion de 70 % à la longueur d'onde considérée.

Le support 28 comprend encore, dans sa partie arrière, une cavité 31 apte à recevoir le photodétecteur 32.

La fibre relais 30 peut avoir 300 µm de diamètre de coeur. Elle est noyée dans le support 28, entre la surface du photodétecteur et le miroir. Elle assure le transfert de la lumière issue de la face arrière du laser 15 vers le photodétecteur 32 à travers le miroir de contre-réaction 26. La résine pure dont est fait le miroir a un indice de 1,5 et est transparente à la longueur d'onde de 1,55 µm. La puissance ainsi recueillie est de l'ordre de 50 µm. Elle est suffisante pour réaliser l'asservissement en puissance par le biais du courant d'alimentation du laser.

Le module thermoélectrique 40, de grande surface, (par exemple 3 cm x 3 cm) couvre une partie de la semelle 34. Il est associé à un capteur thermique placé près de l'embase laser et permet de réaliser une régulation thermique à l'intérieur du boîtier avec une précision de l'ordre de 0,2°C après équilibre pour une température variant de 15 à 20°C. L'ensemble des éléments est intégré dans le boîtier 42 servant de radiateur pour l'élément thermoélectrique.

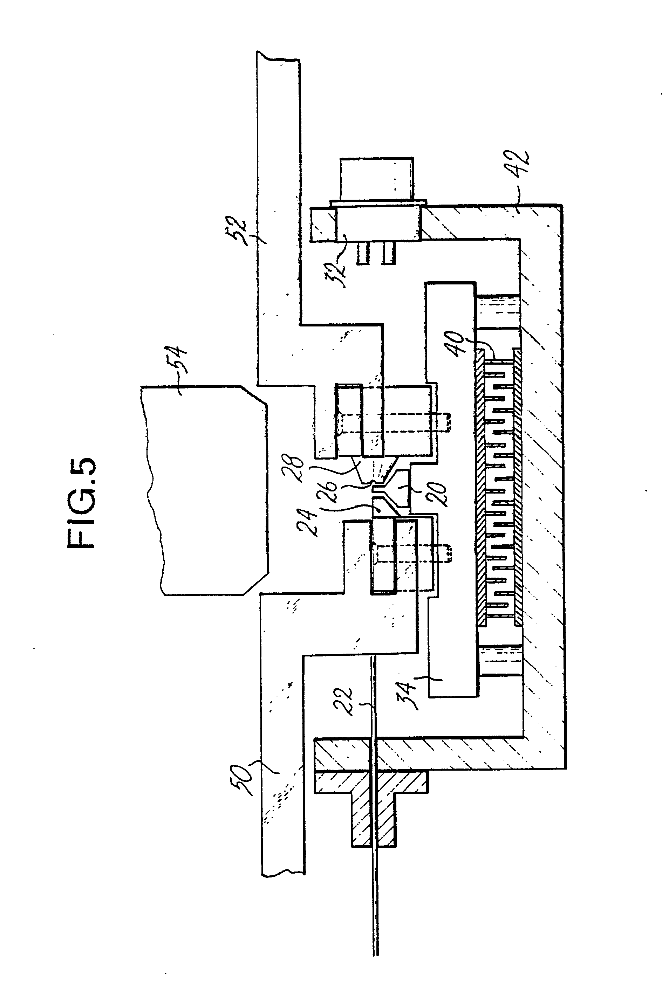

La figure 5 représente une vue d'ensemble du boîtier sur un banc de montage. Un bras manipulateur 50 saisit le support de fibre 24. Il est micromanipulé devant la zone émissive du laser, de façon à réaliser un couplage optimal. Le support est ensuite immobilisé par adjonction de résine autour des piges d'ancrage, cette résine étant la même que celle qui a servi à fabriquer le support. De la même manière, un bras 52 vient saisir le support de miroir 28 et le met en place derrière le laser. L'immobilisation se fait à l'aide de la même résine. L'ensemble des opérations est contrôlé par l'opérateur à travers un instrument d'optique grossissant 54.

**Revendications**

1. Source lumineuse comprenant un laser à semiconducteur (15) émettant un rayonnement par deux faces, un miroir externe (26) servant de sélecteur de mode placé en regard d'une des faces du laser, un photodétecteur (32) recevant une partie du rayonnement émis par le laser et servant à commander le courant d'alimentation du laser pour asservir la puissance émise par le laser, caractérisée par le fait que le photodétecteur (32) est disposé derrière le miroir sélecteur de mode (26), lequel est semitransparent.

2. Source laser selon la revendication 1, caractérisée par le fait que le laser (15) est disposé au sommet d'une embase (20) en forme de toit, le laser émettant à travers ses deux faces deux rayonnements orientés transversalement par rapport au faîte de ce toit.

3. Source laser selon la revendication 2, caractérisée par le fait qu'elle comprend:
- une première fibre optique (22) maintenue par un premier support (24), cette fibre optique étant disposée en regard d'une des faces du laser et guidant le faisceau utile émis par la source,
- une seconde fibre (30) maintenue par un second support (28), lequel maintient egalement le miroir (26) et le photodétecteur (32), cette seconde fibre étant disposée entre le miroir (26) et le photodétecteur (32),
- une semelle (34) sur laquelle repose l'embase (20) et dans laquelle sont fixées des piges d'ancrage (36, 38) traversant les premier et second supports (24, 28) et immobilisant ceux-ci par collage.

4. Source laser selon la revendication 3, caractérisée par le fait que les premier et second supports (24, 28) sont en résine et que cette même résine sert à les coller aux piges d'ancrage (36, 38).

5. Source lumineuse selon la revendication 1, caractérisée par le fait qu'elle comprend, sur la semelle (36), un module thermoélectrique (40) assurant une regulation en température.

6. Source lumineuse selon la revendication 1, caractérisée par le fait que l'ensemble des éléments qui la compose est rassemblé dans un boîtier étanche (42) traversé par la première fibre optique (22).

## Patentansprüche

1. Lichtquelle mit einem Halbleiterlaser (15) der eine Strahlung auf zwei Seiten aussendet, einem äußeren Spiegel (26), der zur Auswahl der Betriebsart dient und einer der Seiten des Lasers gegenüberliegend angeordnet ist, einem Fotodetektor (32), der einen Teil der von dem Laser ausgestrahlten Strahlung erhält und zum Steuern des Versorgungsstromes dient, um die von dem Laser abgegebene Leistung zu steuern, dadurch gekennzeichnet, daß der Fotodetektor (32) hinter dem Spiegel (26) zur Wahl der Betriebsart angeordnet ist, der halbdurchlässig ist.

2. Laserquelle nach Anspruch 1, dadurch gekennzeichnet, daß der Laser (15) auf der Spitze eines dachförmigen Sockels (20) angeordnet ist, wobei der Laser durch seine zwei Seiten hindurch zwei Strahlungen aussendet, die quer in Bezug auf den First dieses Daches ausgerichtet sind.

3. Laserquelle nach Anspruch 2, dadurch gekennzeichnet, daß sie umfaßt:
- eine erste von einer ersten Stütze (24) gehaltene, optische Faser, die einer der Seiten des Lasers gegenüberliegend angeordnet ist und das von der Quelle ausgesandte, verwendbare Bündel leitet,
- eine zweite Faser (30), die von einer zweiten Stütze (28) gehalten ist, welche auch den Spiegel (26) und den Fotodetektor (32) hält, wobei diese zweite Faser zwischen dem Spiegel (26) und dem Fotodetektor (32) angeordnet ist,
- eine Fußplatte (34), auf der der Sockel (20) ruht und in der Verankerungsstäbe (36, 38) befestigt sind, die die erste und die zweite Stütze (24, 28) durchqueren und diese durch Verkleben festlegen.

4. Laserquelle nach Anspruch 3, dadurch gekennzeichnet, daß die erste und die zweite Stütze (24, 28) aus einem Kunstharz bestehen und daß das gleiche Harz dazu dient, sie mit den Verankerungsstäben (36, 38) zu verkleben.

5. Lichtquelle nach Anspruch 1, dadurch gekennzeichnet, daß sie auf der Grundplatte (36) ein thermoelektrisches Modul (40) aufweist, welches eine Temperaturregelung sicherstellt.

6. Lichtquelle nach Anspruch 1, dadurch gekennzeichnet, daß die Gesamtheit der Teile, aus der sie zusammengesetzt ist, in einem dichten Gehäuse (42) zusammengebaut ist, welches von der ersten optischen Faser (22) durchquert wird.

## Claims

1. Luminous source comprising a semiconductor laser (15) emitting radiation through two faces, an external mirror (26) serving as a mode selector located opposite one of the faces of the laser, and a photodetector (32) receiving a part of the radiation emitted by the laser and serving to control the supply current of the laser in order to control automatically the power emitted by the laser, characterized in that the photodetector (32) is disposed behind the mode selector mirror (26), which is semitransparent.

2. Laser source according to Claim 1, characterized in that the laser (15) is disposed at the apex of a base (20) having the shape of a roof, the laser emitting through its two faces two radiations oriented transversely in relation to the vertex of this roof.

3. Laser source according to Claim 2, characterized in that it comprises:
a first optical fibre (22) held by a first support (24), this optical fibre being disposed opposite one of the faces of the laser and guiding the useful beam emitted by the source,
a second fibre (30) held by a second support (28), which also holds the mirror (26) and the photodetector (32), this second fibre being disposed between the mirror (26) and the photodetector (32), and
a bearing plate (34), on which the base (20) rests and in which are fixed anchoring rods (36, 38) passing through the first and second supports (24, 28) and immobilizing the latter by adhesion.

4. Laser source according to Claim 3, characterized in that the first and second supports (24, 28) are made of resin, and in that this same resin serves to cement them to the anchoring rods (36, 38).

5. Luminous source according to Claim 1, characterized in that it comprises, on the bearing plate (36), a thermoelectric module (40) providing temperature regulation.

6. Luminous source according to Claim 1, characterized in that the assembly of the element which composes the source is grouped together in a sealed casing (42) through which the first optical fibre (22) passes.

FIG. 1

# FIG.2

# FIG.3

FIG.4

FIG.5